# EUROPEAN PATENT SPECIFICATION

(11) **EP 2 696 353 B1**
(45) Date of publication and mention of the grant of the patent: **27.06.2018**
(21) Application number: 12767893.6
(22) Date of filing: 30.03.2012
(51) Int. Cl.: H01B 1/22, C22C 9/00, H01L 31/04, H01B 1/16, H01L 31/0224

(54) **PASTE COMPOSITION FOR ELECTRODES, AND SOLAR CELL**
PASTENZUSAMMENSETZUNG FÜR ELEKTRODEN UND SOLARZELLE DAMIT
COMPOSITION DE PÂTE POUR ÉLECTRODE, ET CELLULE SOLAIRE

(30) Priority: 07.04.2011 JP 2011085703
(43) Date of publication of application: 12.02.2014
(73) Proprietor: Hitachi Chemical Company, Ltd., Tokyo 163-0449 (JP)
(72) Inventor: ADACHI, Shuichiro, Tsukuba-shi Ibaraki 300-4247 (JP); YOSHIDA, Masato, Tsukuba-shi Ibaraki 300-4247 (JP); NOJIRI, Takeshi, Tsukuba-shi Ibaraki 300-4247 (JP); IWAMURO, Mitsunori, Tsukuba-shi Ibaraki 300-4247 (JP); KIZAWA, Keiko, Tsukuba-shi Ibaraki 300-4247 (JP); AOYAGI, Takuya, Hitachi-shi Ibaraki 319-1292 (JP); YAMAMOTO, Hiroki, Hitachi-shi Ibaraki 319-1292 (JP); NAITO, Takashi, Hitachi-shi Ibaraki 319-1292 (JP); KATO, Takahiko, Hitachi-shi Ibaraki 319-1292 (JP)
(74) Representative: Hoffmann Eitle
(86) International application number: PCT/JP2012/058680
(87) International publication number: WO 2012/137688

(56) References cited:
- EP-A1- 2 698 827
- WO-A1-2011/090211
- JP-A- 2001 110 232
- JP-A- 2005 222 737
- JP-A- 2010 013 730
- JP-A- 2010 013 730
- JP-A- 2010 059 469
- JP-A- 2010 059 469
- JP-A- 2010 161 331
- JP-A- 2011 171 272
- JP-A- 2011 253 867

## Description

### [Technical Field]

The present invention relates to a paste composition for an electrode and a photovoltaic cell.

### [Background Art]

Generally, a crystalline silicon photovoltaic cell is provided with a surface electrode, in which the wiring resistance or contact resistance of the surface electrode is related to a voltage loss associated with conversion efficiency, and further, the wiring width or shape has an influence on the amount of the incident sunlight (see, for example, Non-Patent Document 1).

The surface electrode of a photovoltaic cell is usually formed in the following manner. That is, a conductive composition is applied onto an n-type semiconductor layer, the n-type semiconductor layer which is formed by thermally diffusing phosphorous and the like at a high temperature on the light-receiving surface side of a p-type silicon substrate, by screen printing or the like, and then sintered the resultant at a high temperature of 800 to 900°C, thereby forming a surface electrode. This conductive composition for forming the surface electrode contains conductive metal powders, glass particles, various additives, and the like.

As the conductive metal powders, silver powders are generally used, but the use of metal powders other than silver powders has been investigated for various reasons. For example, a conductive composition capable of forming an electrode for a photovoltaic cell, including silver and aluminum, is disclosed (see, for example, Patent Document 1). In addition, a composition for forming an electrode, including metal nanoparticles including silver and metal particles other than silver, is disclosed (see, for example, Patent Document 2).

### [Prior Art Document]

### [Patent Document]

[Patent Document 1] Japanese Patent Application Laid-Open (JP-A) No. 2006-313744
[Patent Document 2] JP-A No. 2008-226816 JP 2010 059469 discloses paste compositions with copper particles, JP 2010 013730 and JP 2001 110232 disclose conductive paste compositions with copper phosphorous alloys.
[Non-Patent Document 1] "Sunlight Power Generation, Newest Technology and Systems", edited by Yoshihiro Hamakawa, CMC Books, 2001, p. 26-27

### SUMMARY OF INVENTION

### [Technical Problem]

Silver, which is generally used to form an electrode, is a noble metal and, in view of problems regarding resources and also from the viewpoint that the ore is expensive, proposals for a paste material which replaces the silver-containing conductive composition (silver-containing paste) are desirable. As a promising material for replacing silver, there is copper which is employed in semiconductor wiring materials. Copper is abundant as a resource and the cost of the metal is inexpensive, about as low as one hundredth the cost of silver. However, copper is a material susceptible to oxidation at high temperatures of 200°C or higher. For example, in the composition for forming an electrode described in Patent Document 2, in which the composition includes a copper as a conductive metal, in order to form the electrode by sintering of the composition, it is necessary to conduct a special process in which the composition is sintered under an atmosphere of nitrogen or the like.

It is an object of the present invention to provide a paste composition for an electrode, which is capable of forming an electrode having a low resistivity by inhibiting the oxidation of copper at a time of sintering, and a photovoltaic cell having an electrode in which the electrode is formed by using the paste composition for an electrode.

### [Solution to Problem]

An embodiment of the present invention is a paste composition for an electrode, the paste composition containing: phosphorous-containing copper alloy particles in which a content of phosphorous is from 6% by mass to 8% by mass; glass particles; a solvent; and a resin.

The glass particles preferably have a glass softening point of 600°C or lower and a crystallization starting temperature of higher than 600°C.

A particle diameter (D50) of the phosphorous-containing copper alloy particles is preferably from 0.4 µm to 10 µm.

A particle diameter (D50) of the glass particles is preferably from 0.5 µm to 10 µm.

A ratio of a particle diameter (D50) of the glass particles with respect to a particle diameter (D50) of the phosphorous-containing copper alloy particles is preferably from 0.05 to 100.

The paste composition for an electrode preferably further contains silver particles, and a content of the silver particles is preferably 5% by mass to 65% by mass, when a total content of the phosphorous-containing copper alloy particles and the silver particles is designated as 100% by mass.

A total content of the phosphorous-containing copper alloy particles and the silver particles is preferably from 70% by mass to 94% by mass, a content of the glass particles is preferably from 0.1% by mass to 10% by mass, and a total content of the solvent and the resin is preferably from 3% by mass to 29.9% by mass.

A second embodiment of the present invention is a photovoltaic cell having an electrode, in which the electrode is formed by sintering the paste composition for an electrode, after the paste composition has been applied to a silicon substrate.

### [Advantageous Effects of Invention]

According to the present invention, there is provided a paste composition for an electrode, which is capable of forming an electrode having a low resistivity by inhibiting the oxidation of copper at a time of sintering, and a photovoltaic cell having an electrode in which the electrode is formed by using the paste composition for an electrode.

### BRIEF DESCRIPTION OF DRAWINGS

Fig. 1 is a cross-sectional view of the photovoltaic cell according to the present invention.
Fig. 2 is a plane view showing the light-receiving surface side of the photovoltaic cell according to the present invention.
Fig. 3 is a plane view showing the back surface side of the photovoltaic cell according to the present invention.
Fig. 4(a) is a perspective view showing the AA cross-sectional constitution of the back contact-type photovoltaic cell according to the present invention. Fig. 4(b) is a plane view showing the back surface side electrode structure of the back contact-type photovoltaic cell according to the present invention.

### DESCRIPTION OF EMBODIMENTS

In the present specification, "from...to..." denotes a range including each of the minimum value and the maximum value of the values described before and after the reference.

### <Paste Composition for Photovoltaic Cell Electrode>

A paste composition for an electrode of the present invention includes phosphorous-containing copper alloy particles in which the content of phosphorous is from 6% by mass to 8% by mass; at least one kind of glass particles; at least one kind of solvents; and at least one kind of resins. By adopting such a constitution, it is possible to form an electrode having a low resistivity by inhibiting the oxidation of copper at a time of sintering.

### (Phosphorous-Containing Copper Alloy Particle)

A paste composition for an electrode according to the present invention includes phosphorous-containing copper alloy particles in which the content of phosphorous is from 6% by mass to 8% by mass

The content of phosphorous in the phosphorous-containing copper alloy according to the present invention is from 6% by mass to 8% by mass, preferably from 6.3% by mass to 7.8% by mass, and more preferably from 6.5% by mass to 7.5% by mass, from the viewpoint of the oxidation resistance and the low resistivity. By setting the content of phosphorous in the phosphorous-containing copper alloy to 8% by mass or less, the low resistivity may be more effectively attained and the productivity of the phosphorous-containing copper alloy is excellent. By setting the content of phosphorous in the phosphorous-containing copper alloy to 6% by mass or more, the oxidation resistance may be more effectively attained.

As the phosphorous-containing copper alloy, a brazing material called copper phosphorus brazing (phosphorous concentration: usually approximately 7% by mass or less) is known. The copper phosphorus brazing is used as a copper to copper bonding agent. By using the phosphorous-containing copper alloy particle in the paste composition for an electrode of the present invention, the reducing property of phosphorus against oxidized copper may be utilized to form an electrode having excellent oxidation resistance and low resistivity. Furthermore, it becomes possible to sinter the electrode at a low temperature, and as a result, an effect of reducing a process cost may be attained.

The phosphorous-containing copper alloy particle is an alloy including copper and phosphorous, and it may include other atoms. Examples of other atoms include Ag, Mn, Sb, Si, K, Na, Li, Ba, Sr, Ca, Mg, Be, Zn, Pb, Cd, Tl, V, Sn, Al, Zr, W, Mo, Ti, Co, Ni, and Au.

Further the content of other atoms contained in the phosphorous-containing copper alloy particle may be, for example, 3% by mass or less in the phosphorous-containing copper alloy particle, and from the viewpoint of the oxidation resistance and the low resistivity, it is preferably 1% by mass or less.

The phosphorous-containing copper alloy particles may be used singly or in combination of two or more kinds thereof.

The particle diameter of the phosphorous-containing copper alloy particles is not particularly limited, and it is preferably from 0.4 µm to 10 µm, and more preferably from 1 µm to 7 µm in terms of a particle diameter when the cumulative mass is 50% (hereinafter abbreviated as "D50% in some cases). By setting the particle diameter to 0.4 µm or more, the oxidation resistance is improved more effectively. Further, by setting the particle diameter to 10 µm or less, the contact area at which the phosphorous-containing copper alloy particles contact each other in the electrode increases, whereby the resistivity is reduced more effectively. The particle diameter of the phosphorous-containing copper alloy particle is measured by means of a MICROTRAC particle size distribution analyzer (MT3300 type, manufactured by Nikkiso Co., Ltd.).

In addition, the shape of the phosphorous-containing copper alloy particle is not particularly limited, and it may be any one of a substantially spherical shape, a flat shape, a block shape, a plate shape, a scale-like shape, and the like. From the viewpoint of oxidation resistance and low resistivity, it is preferably a substantially spherical shape, a flat shape, or a plate shape.

The content of the phosphorous-containing copper alloy particles, or the total content of the phosphorous-containing copper alloy particles and the silver particles when including silver particles as described later may be, for example, from 70 to 94% by mass, and from the viewpoint of oxidation resistance and low resistivity, preferably from 72 to 90% by mass, and more preferably from 74 to 88% by mass, based on the paste composition for an electrode of the present invention.

The phosphorous copper alloy may be prepared by a typically used method. Further, the phosphorous-containing copper alloy particles may be prepared by a general method of preparing metal powders using a phosphorous-containing copper alloy that is prepared so as to give a desired phosphorous content with a general method, for example, a water atomization method. The water atomization method is described in Handbook of Metal (Maruzen) or the like.

Specifically, for example, a desired phosphorous-containing copper alloy particle may be prepared by dissolving a phosphorous-containing copper alloy, forming a powder by a nozzle spray, drying the obtained powders, and classifying them. Further, a phosphorous-containing copper alloy particle having a desired particle diameter may be prepared by appropriately selecting the classification condition.

### (Glass Particles)

The paste composition for an electrode according to the present invention includes at least one kind of glass particles. By including the glass particles in the paste composition for an electrode, adhesion between the electrode portion and the substrate is improved at a time of sintering. Furthermore, a silicon nitride film which is an anti-reflection film is removed by a so-called fire-through at an electrode-forming temperature, and an ohmic contact between the electrode and the silicon substrate is formed.

As the glass particles, any known glass particles in the related art may be used without a particular limitation, provided the glass particles are softened or melted at an electrode-forming temperature to contact with the silicon nitride, thereby oxidizing the silicon nitride, incorporating the oxidized silicon dioxide thereof and then removing the silicon nitride film.

In the present invention, the glass particles preferably contain glass having a glass softening point of 600°C or lower and a crystallization starting temperature of higher than 600°C, from the viewpoint of the oxidation resistance and the low resistivity of the electrode. Further, the glass softening point is measured by a general method using a ThermoMechanical Analyzer (TMA), and the crystallization starting temperature is measured by a general method using a ThermoGravimetry/Differential Thermal Analyzer (TG/DTA).

The glass particles generally included in the paste composition for an electrode may be constituted with lead-containing glass, at which silicon dioxide is efficiently captured. Examples of such the lead-containing glass include those described in Japanese Patent 03050064 and the like, which may be preferably used in the present invention.

Furthermore, in the present invention, in consideration of an effect on the environment, it is preferable to use lead-free glass which does not substantially contain lead. Examples of the lead-free glass include lead-free glass described in Paragraphs 0024 to 0025 of JP-A No. 2006-313744, and lead-free glass described in JP-A No. 2009-188281 and the like, and it is also preferable to appropriately select one from the lead-free glass as above for the present invention.

Examples of a glass component to be used in the paste composition for an electrode of the present invention include silicon dioxide (SiO₂), phosphorus oxide (P₂O₅), aluminum oxide (Al₂O₃), boron oxide (B₂O₃), vanadium oxide (V₂O₅), potassium oxide (K₂O), bismuth oxide (Bi₂O₃), sodium oxide (Na₂O), lithium oxide (Li₂O), barium oxide (BaO), strontium oxide (SrO), calcium oxide (CaO), magnesium oxide (MgO), beryllium oxide (BeO), zinc oxide (ZnO), lead oxide (PbO), cadmium oxide (CdO), tin oxide (SnO), zirconium oxide (ZrO₂), tungsten oxide (WO₃), molybdenum oxide (MoO₃), lanthanum oxide (La₂O₃), niobium oxide (Nb₂O₅), tantalum oxide (Ta₂O₅), yttrium oxide (Y₂O₃), titanium oxide (TiO₂), germanium oxide (GeO₂), tellurium oxide (TeO₂), lutetium oxide (Lu₂O₃), antimony oxide (Sb₂O₃), copper oxide (CuO), iron oxide (FeO), silver oxide (AgO) and manganese oxide (MnO).

Among these, it is preferred to use at least one selected from SiO₂, P₂O₅, Al₂O₃, B₂O₃, V₂O₅, Bi₂O₃, ZnO or PbO. Specific examples of the glass component include one which contains SiO₂, PbO, B₂O₃, Bi₂O₃ and Al₂O₃. In the case of such glass particle, since the softening point is effectively lowered and the wettabilities with the phosphorous-containing copper alloy particle and the silver particle added as required are improved, sintering among the above-described particles in the sintering process is advanced, so that an electrode having a low resistivity may be formed.

On another front, from the viewpoint of attaining a low contact resistivity, a glass particle containing diphosphorus pentoxide (phosphate glass, P₂O₅-based glass particle) is preferred and a glass particle which further contains divanadium pentoxide in addition to diphosphorus pentoxide (P₂O₅-V₂O₅-based glass particle) is more preferred. By further containing divanadium pentoxide, the oxidation resistance is more improved and the resistivity of the electrode is further reduced. This may be considered attributable to, for example, a decrease in the glass softening point attained by the further addition of divanadium pentoxide. In cases where a diphosphorus pentoxide-divanadium pentoxide-based glass particle (P₂O₅-V₂O₅-based glass particle) is used, the content of divanadium pentoxide is preferably 1% by mass or more, and more preferably 1 to 70% by mass, based on the total mass of the glass.

The particle diameter of the glass particles of the present invention is not particularly limited, and it is preferably from 0.5 µm to 10 µm, and more preferably from 0.8 µm to 8 µm in terms of a particle diameter when the cumulative mass is 50% ("D50%"). By setting the particle diameter to 0.5 µm or more, workability at the time of preparing a paste composition for an electrode is improved. Further, by setting the particle diameter to 10 µm or less, the glass particles may be dispersed uniformly in the paste composition for an electrode, fire-through may be performed more efficiently in a sintering process, and adhesion to a silicon substrate is also improved.

In addition, the shape of the glass particles is not particularly limited, and it may be any one of a substantially spherical shape, a flat shape, a block shape, a plate shape, a scale-like shape, or the like. From the viewpoint of oxidation resistance and low resistivity, it is preferably a substantially spherical shape, a flat shape, or a plate shape.

Furthermore, a ratio of a particle diameter (D50) of the glass particles with respect to a particle diameter (D50) of the phosphorous-containing copper alloy particles is preferably from 0.05 to 100, and more preferably from 0.1 to 20. By containing the glass particles at a ratio in this range, oxidation resistance, low resistivity of the electrode, and low contact resistance may be more effectively attained.

The content of the glass particles is preferably from 0.1 to 10% by mass, more preferably from 0.5 to 8% by mass, and even more preferably from 1 to 7% by mass, based on the total mass of the paste composition for an electrode. By including the glass particles at a content in this range, oxidation resistance, low resistivity of the electrode, and low contact resistance may be more effectively attained.

### (Solvent and Resin)

The paste composition for an electrode according to the present invention includes at least one kind of solvents and at least one kind of resins, thereby enabling adjustment of the liquid physical properties (for example, viscosity and surface tension) of the paste composition for an electrode of the present invention due to the application method selected when the paste composition is provided on the silicon substrate.

The solvent is not particularly limited. Examples thereof include hydrocarbon-based solvents such as hexane, cyclohexane, and toluene; chlorinated hydrocarbon-based solvents such as dichloroethylene, dichloroethane, and dichlorobenzene; cyclic ether-based solvents such as tetrahydrofuran, furan, tetrahydropyran, pyran, dioxane, 1,3-dioxolane, and trioxane; amide-based solvents such as N,N-dimethylformamide and N,N-dimethylacetamide; sulfoxide-based solvents such as dimethylsulfoxide, diethylsulfoxide; ketone-based solvents such as acetone, methyl ethyl ketone, diethyl ketone, and cyclohexanone; alcohol-based compounds such as ethanol, 2-propanol, 1-butanol, and diacetone alcohol; polyhydric alcohol ester-based solvents such as 2,2,4-trimethyl-1,3-pentanediol monoacetate, 2,2,4-trimethyl-1,3-pentanediol monopropiorate, 2,2,4-trimethyl-1,3-pentanediol monobutyrate, 2,2,4-trimethyl-1,3-pentanediol monoisobutyrate, 2,2,4-triethyl-1,3-pentanediol monoacetate, ethylene glycol monobutyl ether acetate, and diethylene glycol monobutyl ether acetate; polyhydric alcohol ether-based solvents such as butyl cellosolve and diethylene glycol diethyl ether; terpene-based solvents such as α-terpinene, α-terpineol, myrcene, alloocimene, limonene, dipentene, α-pinene, β-pinene, terpineol, carvone, ocimene, and phellandrene; and mixtures thereof.

As the solvent in the present invention from the viewpoint of applicability and printability when forming the paste composition for an electrode on a silicon substrate, at least one selected from polyhydric alcohol ester-based solvents, or terpene-based solvents, and polyhydric alcohol ether-based solvents is preferred, and at least one selected from polyhydric alcohol ester-based solvents or terpene-based solvents is more preferred.

In the present invention, the solvents may be used singly or in a combination of two or more kinds thereof.

Furthermore, as the resin, a resin that is usually used in the art may be used without any limitation as long as it is a resin that is thermally decomposable by sintering. Specific examples thereof include cellulose-based resins such as methyl cellulose, ethyl cellulose, carboxymethyl cellulose, and nitrocellulose; polyvinyl alcohols; polyvinyl pyrrolidones; acryl resins; vinyl acetate-acrylic ester copolymers; butyral resins such as polyvinyl butyral; alkyd resins such as phenol-modified alkyd resins and castor oil fatty acid-modified alkyd resins; epoxy resins; phenol resins; and rosin ester resins.

As the resin in the present invention, from the viewpoint of the loss at a time of sintering, at least one selected from cellulose-based resins or acryl resins are preferred, and at least one selected from cellulose-based resins is more preferred.

In the present invention, the resins may be used singly or in combination of two or more kinds thereof.

Further, the weight average molecular weight of the above-described resin in the present invention is preferably from 5,000 to 500,000. When the weight average molecular weight of the resin is 5,000 or higher, an increase in the viscosity of the paste composition for an electrode may be suppressed. This may be considered because, for example, the phenomenon of particle aggregation, which is caused by insufficient steric repulsion when the resin is adsorbed on the phosphorous-containing copper alloy particle, is suppressed. Meanwhile, when the weight average molecular weight of the resin is 500,000 or lower, the resins mutually aggregates in the solvent, so that the phenomenon of increase in the viscosity of the paste composition for an electrode may be suppressed. In addition, by controlling the weight average molecular weight of the resin at an appropriate level, an increase in the combustion temperature of the resin may be inhibited and, therefore, a residual foreign substance caused by incomplete combustion of the resin during sintering of the paste composition for an electrode may be prevented, so that an electrode having a low resistivity may be attained.

In the paste composition for an electrode according to the present invention, the contents of the solvent and the resin may be appropriately selected in accordance with desired liquid physical properties and the kinds of the solvent and the resin to be used. For example, the total content of the solvent and the resin is preferably 3 to 29.9% by mass, more preferably 5 to 25% by mass, and even more preferably 7 to 20% by mass, based on the total mass of the paste composition for an electrode.

By setting the contents of the solvent and the resin in the above-described ranges, the provision suitability becomes better when the paste composition for an electrode is provided on a silicon substrate, and thus, an electrode having a desired width and a desired height may be formed more easily.

### (Silver Particles)

The paste composition for an electrode of the present invention preferably further includes a silver particle. By including the silver particle, the oxidation resistance is further improved, and the resistivity as the electrode is further reduced. In addition, an effect that the solder connectivity is improved when forming a photovoltaic cell module may be obtained. This may be considered to be as follows, for example.

Generally, in a temperature region from 600°C to 900°C that is an electrode-forming temperature region, a small amount of a solid solution of silver in copper and a small amount of a solid solution of copper in silver are generated, and a layer of the copper-silver solid solution (solid solution region) is formed at an interface between copper and silver. It is thought that when a mixture of the phosphorous-containing copper alloy particles and the silver particles is heated at a high temperature, and then slowly cooled to room temperature, the solid solution region is not generated, but taking into consideration that cooling is done for a few seconds from a high temperature region to a normal temperature when forming an electrode, it is thought that the layer of the solid solution at a high temperature covers the surface of the silver particles and the phosphorous-containing copper alloy particles as a non-equilibrium solid solution phase or as an eutectic structure of copper and silver. It may be thought that such the copper-silver solid solution layer contributes to the oxidation resistance of the phosphorous-containing copper alloy particle at an electrode-forming temperature.

Silver constituting the silver particles may contain other atoms which are inevitably incorporated. Examples of other atoms which are inevitably incorporated include Sb, Si, K, Na, Li, Ba, Sr, Ca, Mg, Be, Zn, Pb, Cd, Tl, V, Sn, Al, Zr, W, Mo, Ti, Co, Ni, and Au.

The particle diameter of the silver particle of the present invention is not particularly limited, and it is preferably 0.4 µm to 10 µm, and more preferably 1 µm to 7 µm in terms of a particle diameter when the cumulative mass is 50% ("D50%"). By setting the particle diameter to 0.4 µm or more, the oxidation resistance is improved more effectively. Further, by setting the particle diameter to 10 µm or less, the contact area between the metal particles such as silver particles and phosphorous-containing copper alloy particles in the electrode increases, and thus, the resistivity is more effectively reduced.

In the paste composition for an electrode of the present invention, the relationship between the particle diameter of the phosphorous-containing copper alloy particle (D50%) and the particle diameter of the silver particle (D50%) is not particularly limited, and it is preferable that the particle diameter (D50%) of one is smaller than the particle diameter (D50%) of the other, and it is more preferable that the ratio of the particle diameter of one to the particle diameter of the other be 1 to 10. Consequently, the resistivity of the electrode is more effectively reduced. It is thought that this is caused from increase in the contact area between the metal particles such as phosphorous-containing copper alloy particles and silver particles in the electrode.

Moreover, the content of the silver particles in the paste composition for an electrode of the present invention is preferably 8.4 to 85.5% by mass, and more preferably 8.9 to 80.1% by mass, based on the paste composition for an electrode, from the viewpoint of the oxidation resistance and the low resistivity of the electrode.

Moreover, in the present invention, from the viewpoint of the oxidation resistance, the low resistivity of the electrode, and reduction in cost, the content of the silver particles is preferably 5 to 65% by mass, more preferably 7 to 60% by mass, and even more preferably 10 to 55% by mass, when a total content of the phosphorous-containing copper alloy particles and the silver particles is designated as 100% by mass.

Moreover, in the paste composition for an electrode of the present invention, from the viewpoint of the oxidation resistance, the low resistivity of the electrode, and the applicability on a silicon substrate, the total content of the phosphorous-containing copper alloy particles and the silver particles is preferably 70% by mass to 94% by mass, and more preferably 74% by mass to 88% by mass. By setting the total content of the phosphorous-containing copper alloy particles and the silver particles to 70% by mass or more, a viscosity that is suitable for providing the paste composition for an electrode may be easily attained. Also, by setting the total content of the phosphorous-containing copper alloy particles and the silver particles to 94% by mass or less, the occurrence of abrasion when providing the paste composition for an electrode may be more effectively inhibited.

Moreover, in the paste composition for an electrode of the present invention, from the viewpoint of the oxidation resistance and the low resistivity of the electrode, it is preferable that the total content of the phosphorous-containing copper alloy particles and the silver particles be 70% by mass to 94% by mass, the content of the glass particles be 0.1% by mass to 10% by mass, and the total content of the solvent and the resin be 3% by mass to 29.9% by mass; it is more preferable that the total content of the phosphorous-containing copper alloy particles and the silver particles be 74% by mass to 88% by mass, the content of the glass particles be 0.5% by mass to 8% by mass, and the total content of the solvent and the resin be 7% by mass to 20% by mass; and it is still more preferable that the total content of the phosphorous-containing copper alloy particles and the silver particles be 74% by mass to 88% by mass, the content of the glass particles be 1% by mass to 7% by mass, and the total content of the solvent and the resin be 7% by mass to 20% by mass.

### (Flux)

The paste composition for an electrode may include at least one kind of fluxs. By including the flux, the oxidation resistance is further improved, and the resistivity of the electrode to be formed is further reduced. Also, an effect that adhesion between the electrode material and the silicon substrate is improved may be attained.

The flux in the present invention is not particularly limited as long as it can remove an oxide film formed on the surface of the phosphorous-containing copper alloy particles. Specific preferable examples of the flux include fatty acids, boric acid compounds, fluoride compounds, and fluoroborate compounds.

More specific examples thereof include lauric acid, myristic acid, palmitic acid, stearic acid, sorbic acid, stearol acid, boron oxide, potassium borate, sodium borate, lithium borate, potassium fluoroborate, sodium fluoroborate, lithium fluoroborate, acidic potassium fluoride, acidic sodium fluoride, acidic lithium fluoride, potassium fluoride, sodium fluoride, and lithium fluoride.

Among those, from the viewpoint of heat resistance at a time of sintering the electrode material (a property that the flux is not volatilized at a low sintering temperature) and complement of the oxidation resistance of the phosphorous-containing copper alloy particles, particularly preferable examples of the flux include potassium borate and potassium fluoroborate.

In the present invention, these fluxes may be respectively used singly or in combination of two or more kinds thereof.

Furthermore, the content of the flux in the paste composition for an electrode of the present invention is preferably from 0.1 to 5% by mass, more preferably from 0.3 to 4% by mass, even more preferably from 0.5 to 3.5% by mass, still more preferably from 0.7 to 3% by mass, and particularly preferably from 1 to 2.5% by mass, based on the total mass of the paste composition for an electrode, from the viewpoint of effectively exhibiting the oxidation resistance of the phosphorous-containing copper alloy particles and from the viewpoint of reducing the porosity of a portion from which the flux is removed at a time of completion of the sintering of the electrode material.

### (Other Components)

Furthermore, the paste composition for an electrode of the present invention may include, in addition to the above-described components, other components generally used in the art, if necessary. Examples of other components include a plasticizer, a dispersant, a surfactant, an inorganic binder, a metal oxide, a ceramic, and an organic metal compound.

The method of preparing the paste composition for an electrode of the present invention is not particularly limited. The paste composition for an electrode of the present invention may be prepared by dispersing and mixing phosphorous-containing copper alloy particles, glass particles, a solvent, a resin, silver particles to be added, if necessary, and the like, using a typically used dispersing/mixing method.

### <Method of producing electrode using paste composition for electrode>

As a method of producing an electrode by using the paste composition for an electrode of the present invention, an electrode may be formed in a desired region by providing the above-described paste composition for an electrode to the region where an electrode is to be formed and then drying and sintering the resultant. By using the above-described paste composition for an electrode, an electrode having a low resistivity may be formed even when the sintering treatment is performed in the presence of oxygen (e.g. in the atmosphere).

Specifically, for example, in cases where an electrode for a photovoltaic cell is formed using the above-described paste composition for an electrode, a photovoltaic cell electrode having a low resistivity may be formed in a desired shape by providing the paste composition for an electrode to a silicon substrate in a desired shape and then drying and sintering the resultant. Further, by using the above-described paste composition for an electrode, an electrode having a low resistivity may be formed even when the sintering treatment is performed in the presence of oxygen (e.g. in the atmosphere).

Examples of the method for providing the paste composition for an electrode on a silicon substrate include screen printing, an ink-jet method, and a dispenser method, and from the viewpoint of the productivity, application by screen printing is preferred.

When the paste composition for an electrode of the present invention is applied by screen printing, it is preferable that the viscosity be in the range from 80 to 1000 Pa·s. Further, the viscosity of the paste composition for an electrode is measured using a Brookfield HBT viscometer at 25°C.

The amount of the paste composition for an electrode to be applied may be selected as appropriate in accordance with the size of the electrode to be formed. For example, the paste composition for an electrode may be applied in an amount of 2 to 10 g/m², and preferably 4 to 8 g/m2.

Moreover, as a heat treatment condition (sintering condition) when forming an electrode using the paste composition for an electrode of the present invention, heat treatment conditions generally used in the art may be applied.

Generally, the heat treatment temperature (sintering temperature) is 800 to 900°C, but when using the paste composition for an electrode of the present invention, a heat treatment condition at a lower temperature may be applied, and for example, an electrode having excellent characteristics may be formed at a heat treatment temperature of 600 to 850°C.

In addition, the heat treatment time may be appropriately selected according to the heat treatment temperatures, and it may be, for example, 1 second to 20 seconds.

As a heat treatment apparatus, any apparatus may be employed as appropriate as long as it is capable of heating the paste composition to the above-described temperature, and examples of such apparatus include infrared heating ovens and tunnel ovens. In an infrared heating oven, electrical energy is directly charged to the material to be heated in the form of an electromagnetic wave and converted into thermal energy; therefore, an infrared heating oven is highly efficient and capable of attaining rapid heating in a short period of time. Further, since no combustion product is generated and the heating is non-contact heating, contamination of the produced electrode may be prevented. In a tunnel oven, a sample is sintered while being conveyed automatically and continuously from an inlet to an outlet; therefore, by segmenting the oven and controlling the conveying speed, uniform sintering may be attained. From the viewpoint of the power generation performance of the resulting photovoltaic cell, it is preferred that the heat treatment be performed by a tunnel oven.

### <Photovoltaic cell>

The photovoltaic cell of the present invention has an electrode formed by sintering the paste composition for an electrode, after the paste composition has been applied to the silicon substrate. As a result, a photovoltaic cell having excellent properties can be obtained, and the productivity of the photovoltaic cell is excellent.

Hereinbelow, specific examples of the photovoltaic cell of the present invention will be described with reference to the drawings, but the present invention is not limited thereto.

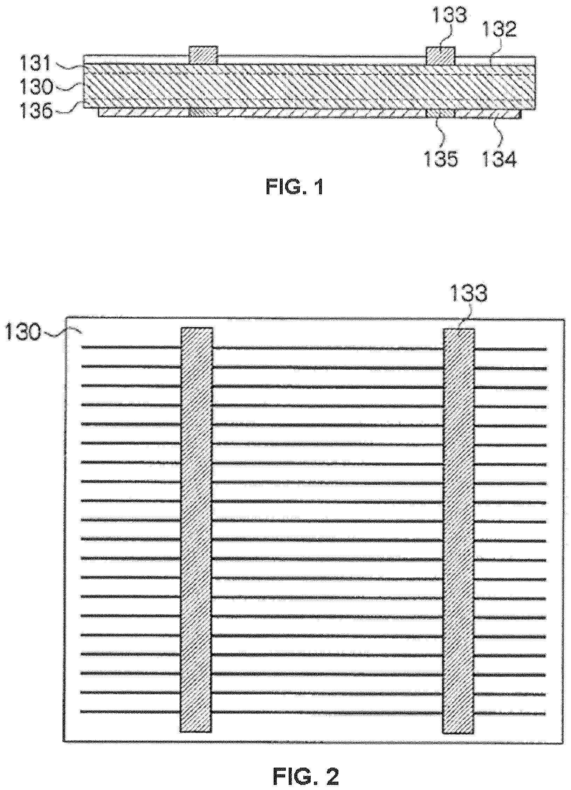

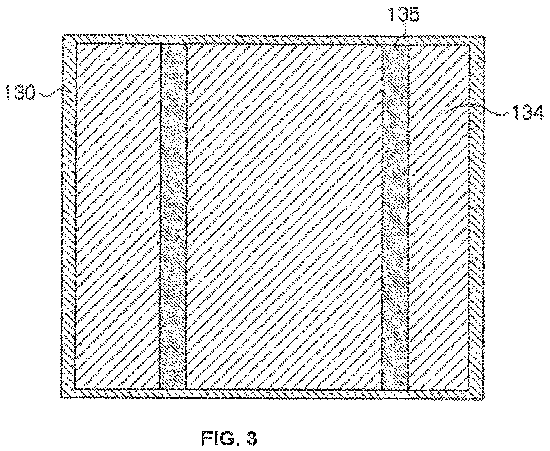

A cross-sectional view, and summaries of the light-receiving surface and the back surface of one example of the representative photovoltaic cell elements are shown in Figs. 1, 2, and 3, respectively.

Typically, monocrystalline or polycrystalline Si, or the like is used as a semiconductor substrate 130 of a photovoltaic cell element. This semiconductor substrate 130 contains boron and the like to constitute a p-type semiconductor. Unevenness (texture, not shown) is formed on the light-receiving surface side by etching so as to inhibit the reflection of sunlight. Phosphorous and the like are doped on the light-receiving surface side, a diffusion layer 131 of an n-type semiconductor with a thickness on the order of submicrons is provided, and a p/n junction is formed on the boundary with the p-type bulk portion. Also, on the light-receiving surface side, an anti-reflection layer 132 such as silicon nitride with a film thickness of around 100 nm is provided on the diffusion layer 131 by a vapor deposition method.

Next, a light-receiving surface electrode 133 provided on the light-receiving surface side, a current collection electrode 134 and an output extraction electrode 135 formed on the back surface will be described. The light-receiving surface electrode 133 and the output extraction electrode 135 are formed from the paste composition for an electrode. Further, the current collection electrode 134 is formed from the aluminum electrode paste composition including glass powders. These electrodes are formed by applying the paste composition for a desired pattern by screen printing or the like, drying, and then sintering at about 600 to 850°C in an atmosphere.

In the present invention, by using the above-described paste composition for an electrode, an electrode having excellent resistivity and contact resistivity may be formed even when the sintering is performed at a relatively low temperature.

Here, on the light-receiving surface side, the glass particles which are included in the paste composition for an electrode forming the light-receiving surface electrode 133 undergo a reaction (fire-through) with the anti-reflection layer 132, thereby electrically connecting (ohmic contact) the light-receiving surface electrode 133 and the diffusion layer 131.

In the present invention, by using the above-described paste composition for an electrode to form the light-receiving surface electrode 133, the light-receiving surface electrode 133 which includes copper as a conductive metal, inhibits the oxidation of copper, and has a low resistivity is formed with high productivity.

Further, on the back surface side, while sintering, aluminum in the aluminum electrode paste composition forming the current collection electrode 134 is diffused onto the back surface of the semiconductor substrate 130 to form an electrode component diffusion layer 136, and as a result, ohmic contact among the semiconductor substrate 130, the current collection electrode 134, and the output extraction electrode 135 may be obtained.

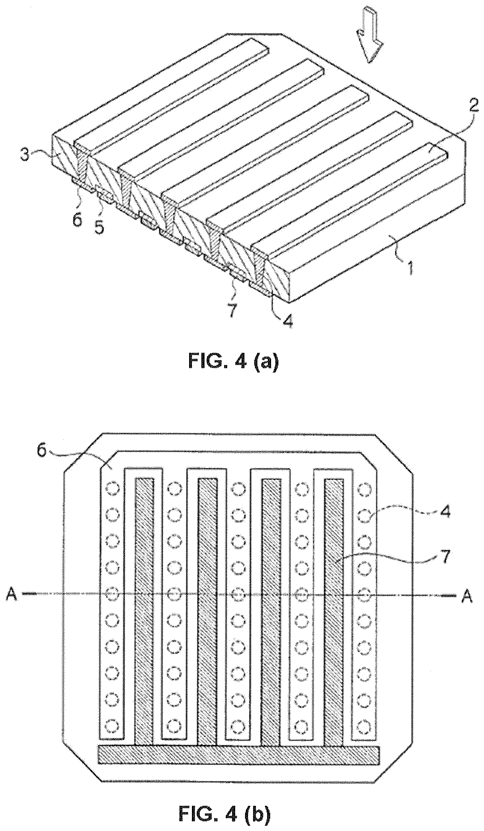

Furthermore, the perspective view (a) of the light-receiving surface and the AA cross-section structure, and the plane view (b) of the back surface side electrode structure of one example of the photovoltaic cell element which is another embodiment of the present invention are shown in Fig. 4.

As shown in Fig. 4(a), in a cell wafer 1 including a silicon substrate of a p-type semiconductor, a through-hole which passes through both sides of the light-receiving surface side and the back surface side is formed by laser drilling, etching, or the like. Further, a texture (not shown) improving the efficiency of incident light is formed on the light-receiving surface side. Also, the n-type semiconductor layer 3 by n-type diffusion treatment is formed on the light-receiving surface side, and an anti-reflection film (not shown) is formed on the n-type semiconductor layer 3. These are prepared by the same processes as for a cell of a conventional crystal Si-type photovoltaic cell.

Next, the paste composition for an electrode of the present invention is filled in the inside of the through-hole previously formed by a printing method or an ink-jet method, and also, the paste composition for an electrode of the present invention is similarly printed in the grid shape on the light-receiving surface side, thereby forming a composition layer which forms the through-hole electrode 4 and the grid electrode 2 for current collection.

Here, in the paste used for filling and printing, a paste having a composition optimal for each process including viscosity is preferably used, but a paste have the same composition may be filled or printed in bulk.

On the other hand, a high-concentration doped layer 5 is formed on the opposite side of the light-receiving surface (back surface side) so as to prevent the carrier recombination. Here, as an impurity element forming the high-concentration doped layer 5, boron (B) or aluminum (Al) is used, and a p⁺ layer is formed. This high-concentration doped layer 5 may be formed by carrying out a thermal diffusion treatment using, for example, B as a diffusion source in the process of preparing a cell before forming the anti-reflection film, or when using Al, it may also be formed by printing an Al paste on the opposite surface side in the printing process.

Thereafter, the paste composition for an electrode which is sintered at 650 to 850°C, and filled and printed on an anti-reflection film formed in the inside of the through-hole and on the light-receiving surface side may attain ohmic contact with the lower n-type layer by a fire-through effect.

Furthermore, as shown in the plane view of Fig. 4(b), the paste composition for an electrode according to the present invention is printed in stripe shapes on each of the n side and the p side, and sintered, and thus, the back surface electrodes 6 and 7 are formed on the opposite surface side.

In the present invention, the through-hole electrode 4, the grid electrode 2 for current collection, the back surface electrode 6, and the back surface electrode 7 are formed using the paste composition for an electrode, and thus, the through-hole electrode 4, the grid electrode 2 for current collection, the back surface electrode 6, and the back surface electrode 7, each of which includes copper as a conductive metal, inhibits the oxidation of copper, and has a low resistivity, are formed with high productivity.

Moreover, the paste composition for an electrode for a photovoltaic cell of the present invention is not restricted to the applications of photovoltaic cell electrodes, and may also be appropriately used in applications such as, for example, electrode wirings and shield wirings of plasma displays, ceramic condensers, antenna circuits, various sensors circuits, and heat dissipation materials of semiconductor devices.

### EXAMPLES

Hereinbelow, the present invention will be described in detail with reference to Examples, but the present invention is not limited to these Examples. Further, unless otherwise specified, "parts" and "%" are based on mass.

### <Example 1>

### (a) Preparation of Paste Composition for Electrode

A phosphorous-containing copper alloy particles including 7% by mass of phosphorous is prepared, dissolved, made into powder by a water atomization method, then dried and classified. The classified powders were blended and subjected to deoxidation/dehydration treatments to prepare phosphorous-containing copper alloy particles including 7% by mass of phosphorous. Further, the particle diameter of the phosphorous-containing copper alloy particle (D50%) was 1.5 µm.

A glass including 3 parts of silicon dioxide (SiO₂), 60 parts of lead oxide (PbO), 18 parts of boron oxide (B₂O₃), 5 parts of bismuth oxide (Bi₂O₃), 5 part of aluminum oxide (Al₂O₃), and 9 parts of zinc oxide (ZnO) (hereinafter abbreviated as "G1" in some cases) was prepared. The glass G1 obtained had a softening point of 420°C and a crystallization temperature of higher than 600°C.

By using the glass G1 obtained, glass particles having a particle diameter (D50%) of 1.7 µm were obtained.

Then, 85.1 parts of the thus obtained phosphorous-containing copper alloy particle, 1.7 parts of the glass particle and 13.2 parts of a terpineol (isomeric mixture) solution containing 3% by mass of ethyl cellulose (EC, weight average molecular weight of 190,000) were mixed and stirred in an agate mortar for 20 minutes to prepare a paste composition 1 for an electrode.

### (b) Preparation of Photovoltaic Cell

A p-type semiconductor substrate having a film thickness of 190 µm, in which an n-type semiconductor layer, a texture, and an anti-reflection film (silicon nitride film) were formed on the light-receiving surface, was prepared, and cut to a size of 125 mm×125 mm. The paste composition 1 for an electrode obtained above was printed on the light-receiving surface for an electrode pattern as shown in Fig. 2, using a screen printing method. The pattern of the electrode was constituted with finger lines with a 150 µm width and bus bars with a 1.1 mm width, and the printing conditions (a mesh of a screen plate, a printing speed, a printing pressure) were appropriately adjusted so as to give a film thickness after sintering of 20 µm. The resultant was put into an oven heated at 150°C for 15 minutes, and the solvent was removed by evaporation.

Subsequently, an aluminum electrode paste was similarly printed on the entire surface of the back surface by screen printing. The printing conditions were appropriately adjusted so as to give a film thickness after sintering of 40 µm. This was put into an oven heated at 150°C for 15 minutes, and the solvent was removed by evaporation.

Thereafter, using a tunnel oven (manufactured by Noritake Co., Limited; single W/B conveyor tunnel furnace), a heat treatment (sintering) was performed in the atmosphere at the maximum sintering temperature of 850°C for a retention time of 10 seconds to prepare a photovoltaic cell 1 in which desired electrodes were formed.

### <Example 2>

A photovoltaic cell 2 was prepared in the same manner as in Example 1, except that the sintering conditions for the electrode formation were changed from 10 seconds at the maximum temperature of 850°C to 15 seconds at the maximum temperature of 750°C.

### <Example 3>

A paste composition 3 for an electrode and a photovoltaic cell 3 were prepared in the same manner as in Example 1, except that the particle diameter of the phosphorous-containing copper alloy particle was changed from 1.5 µm to 5.0 µm.

### <Example 4>

A paste composition 4 for an electrode and a photovoltaic cell 4 were prepared in the same manner as in Example 1, except that the phosphorous content of the phosphorous-containing copper alloy particle was changed from 7% by mass to 6% by mass.

### <Example 5>

A paste composition 5 for an electrode and a photovoltaic cell 5 were prepared in the same manner as in Example 1, except that the phosphorous content of the phosphorous-containing copper alloy particle was changed from 7% by mass to 8% by mass.

### <Example 6>

A paste composition 6 for an electrode and a photovoltaic cell 6 were prepared in the same manner as in Example 3, except that a silver particle (particle diameter (D50%) of 3 µm; high-purity chemical product manufactured by Aldrich) was further added.

Specifically, the paste composition 6 for an electrode containing 75.0 parts of the phosphorous-containing copper alloy particle (phosphorous content of 7% by mass, particle diameter (D50%) of 5 µm), 10.1 parts of the silver particle, 1.7 parts of the glass particle (G1) and 13.2 parts of the terpineol (isomeric mixture) solution containing 3% by mass of ethyl cellulose (EC) was prepared, and the photovoltaic cell 6 was produced in the same manner as in Example 3 except that the thus obtained paste composition 6 for an electrode was used.

### <Examples 7 to 17>

Paste compositions 7 to 17 for an electrode were prepared in the same manner as in Example 1, except that the phosphorous content, particle diameter (D50%) and content of the phosphorous-containing copper alloy particle, as well as the content of the silver particle, the type and content of the glass particle and the content of the terpineol solution containing 3% of ethyl cellulose (EC), were changed as shown in Table 1.

It is noted here that the glass particle (G2) consists of 45 parts of vanadium oxide (V₂O₅), 24.2 parts of phosphorus oxide (P₂O₅), 20.8 parts of barium oxide (BaO), 5 parts of antimony oxide (Sb₂O₃) and 5 parts of tungsten oxide (WO₃) and had a particle diameter (D50%) of 1.7 µm. Further, the softening point of this glass was 492°C and the crystallization temperature was higher than 600°C.

Then, photovoltaic cells 7 to 11 having desired electrodes were each produced in the same manner as in Example 1, except that the respective paste compositions 7 to 17 for an electrode were used and the temperature and time of the heat treatment were changed as shown in Table 1.

### <Comparative Example 1>

A paste composition C1 for an electrode was prepared in the same manner as in Example 1, except that the phosphorous-containing copper alloy particle was not used and the components were changed in accordance with the composition shown in Table 1.

A photovoltaic cell C1 was produced in the same manner as in Example 1, except that the paste composition C1 for an electrode not containing the phosphorous-containing copper alloy particle was used.

### <Comparative Example 2>

A photovoltaic cell C2 was produced in the same manner as in Comparative Example 1, except that the sintering conditions for the electrode formation were changed from 10 seconds at the maximum temperature of 850°C to 15 seconds at the maximum temperature of 750°C.

### <Comparative Example 3>

A paste composition C3 for an electrode was prepared in the same manner as in Example 1, except that pure copper not containing phosphorus (phosphorous content: 0%) was used in place of the phosphorous-containing copper alloy particle.

A photovoltaic cell C3 was produced in the same manner as in Example 1, except that the thus obtained paste composition C3 for an electrode was used.

### <Comparative Example 4>

A photovoltaic cell C4 was produced in the same manner as in Comparative Example 1, except that the sintering conditions for the electrode formation in Comparative Example 3 were changed from 10 seconds at the maximum temperature of 850°C to 20 seconds at the maximum temperature of 700°C.

**[Table 1]**

| Example | Phosphorous-containing copper alloy particles | | | Silver particles | | Glass particles | | 3% EC-containing terpineol solution (parts) | Sintering Condition | |
|---|---|---|---|---|---|---|---|---|---|---|
| | Content (parts) | Content of Phosphorous (wt%) | Particle diameter (D50%) (µm) | Content (parts) | Particle diameter (D50%) (µm) | Type | Content (parts) | | Top temperature at sintering | Treatment time at top temperature |
| Example 1 | 85.1 | 7 | 1.5 | 0 | - | G1 | 1.7 | 13.2 | 850 | 10 |
| Example 2 | 85.1 | 7 | 1.5 | 0 | - | G1 | 1.7 | 13.2 | 750 | 15 |
| Example 3 | 85.1 | 7 | 5.0 | 0 | - | G1 | 1.7 | 13.2 | 850 | 10 |
| Example 4 | 85.1 | 6 | 1.5 | 0 | - | G1 | 1.7 | 13.2 | 850 | 10 |
| Example 5 | 85.1 | 8 | 1.5 | 0 | - | G1 | 1.7 | 13.2 | 850 | 10 |
| Example 6 | 75.0 | 7 | 5.0 | 10.1 | 3 | G1 | 1.7 | 13.2 | 850 | 10 |
| Example 7 | 75.0 | 7 | 5.0 | 10.1 | 3 | G1 | 1.7 | 13.2 | 750 | 15 |
| Example 8 | 59.5 | 7 | 5.0 | 25.6 | 3 | G1 | 1.7 | 13.2 | 850 | 10 |
| Example 9 | 39.2 | 7 | 5.0 | 45.9 | 3 | G1 | 1.7 | 13.2 | 850 | 10 |
| Example 10 | 75.0 | 7 | 5.0 | 10.1 | 3 | G2 | 2.0 | 13.2 | 850 | 10 |
| Example 11 | 73.5 | 7 | 5.0 | 9.9 | 3 | G2 | 3.4 | 13.2 | 850 | 10 |
| Example 12 | 75.0 | 8 | 1.5 | 10.1 | 3 | G2 | 1.7 | 13.2 | 850 | 10 |
| Example 13 | 75.0 | 8 | 1.5 | 10.1 | 3 | G2 | 1.7 | 13.2 | 750 | 15 |
| Example 14 | 75.0 | 8 | 1.5 | 10.1 | 3 | G2 | 1.7 | 13.2 | 700 | 20 |
| Example 15 | 73.5 | 8 | 1.5 | 9.9 | 3 | G1 | 3.4 | 13.2 | 850 | 10 |
| Example 16 | 79.3 | 7 | 5.0 | 0 | - | G1 | 1.7 | 19.0 | 850 | 10 |
| Example 17 | 53.7 | 7 | 5.0 | 25.6 | 3 | G1 | 1.7 | 19.0 | 750 | 15 |
| Comp. Example 1 | - | - | - | 85.1 | 3 | G1 | 1.7 | 13.2 | 850 | 10 |
| Comp. Example 2 | - | - | - | 85.1 | 3 | G1 | 1.7 | 13.2 | 750 | 15 |
| Comp. Example 3 | 85.1 | 0 | 1.5 | 0 | - | G1 | 1.7 | 13.2 | 850 | 10 |
| Comp. Example 4 | 85.1 | 0 | 1.5 | 0 | - | G1 | 1.7 | 13.2 | 700 | 20 |

### <Evaluation>

The photovoltaic cells prepared were evaluated with a combination of WXS-155 S-10 manufactured by Wacom-Electric Co., Ltd. as artificial sunlight and a measurement device of I-V CURVE TRACER MP-160 (manufactured by EKO INSTRUMENT CO., LTD.) as a current-voltage (I-V) evaluation and measurement device. Eff (conversion efficiency), FF (fill factor), Voc (open voltage), and Jsc (short circuit current) indicating the power generation performances as a photovoltaic cell were obtained by carrying out the measurement in accordance with each of JIS-C-8912, JIS-C-8913, and JIS-C-8914. Each of the values measured are shown in Table 2 in terms of a relative value when the value measured in Comparative Example 1 was taken as 100.0.

Comparative Examples 3 and 4 were unmeasurable due to increase of the resistivity of the each electrode by the oxidation of copper particles.

**[Table 2]**

| Example | Power generation performance as photovoltaic cell | | | |
|---|---|---|---|---|
| | Eff (relative value) Conversion efficiency | FF (relative value) Fill factor | Voc (relative value) Open voltage | Jsc (relative value) Short circuit current |
| Example 1 | 100.6 | 100.2 | 100.0 | 101.1 |
| Example 2 | 99.8 | 98.9 | 95.9 | 100.1 |
| Example 3 | 100.3 | 101.1 | 99.8 | 99.8 |
| Example 4 | 101.5 | 100.8 | 101.2 | 102.2 |
| Example 5 | 99.8 | 99.7 | 100.1 | 99.6 |
| Example 6 | 101.1 | 100.2 | 98.2 | 101.2 |
| Example 7 | 100.9 | 100.1 | 99.1 | 100.4 |
| Example 8 | 101.8 | 100.8 | 100.1 | 99.8 |
| Example 9 | 102.8 | 102.5 | 100.3 | 103.0 |
| Example 10 | 102.3 | 100.9 | 100.5 | 100.3 |
| Example 11 | 102.2 | 101.1 | 100.2 | 99.9 |
| Example 12 | 99.7 | 98.9 | 98.0 | 100.1 |
| Example 13 | 99.1 | 99.0 | 98.4 | 99.2 |
| Example 14 | 97.9 | 98.1 | 95.5 | 99.2 |
| Example 15 | 101.1 | 99.4 | 100.1 | 100.3 |
| Example 16 | 100.0 | 99.7 | 99.6 | 100.3 |
| Example 17 | 99.2 | 98.0 | 98.2 | 99.4 |
| Comparative Example 1A | 100.0 | 100.0 | 100.0 | 100.0 |
| Comparative Example 2 | 68.7 | 70.4 | 80.2 | 69.9 |
| Comparative Example 3 | - | - | - | - |
| Comparative Example 4 | - | - | - | - |

The performances of the photovoltaic cells prepared in Examples 1 to 17 were about the same or superior as compared to the measured values of Comparative Example 1. Particularly, the photovoltaic cells 1 to 5 and 16 exhibited high power generation performances although their electrodes were formed without silver particle.

Further, when the X-ray diffraction was measured by X-ray diffraction method with CuKα ray, the light-receiving surface electrodes of the photovoltaic cells 1 to 5 and 16 showed diffraction peaks characteristic to copper at least at diffraction angles (20, CuKα ray) of 43.4°, 50.6° and 74.2°. As the reason for such detection of copper from the light-receiving surface electrodes, the following principle is considered.

First, in the paste compositions for an electrode 1 to 5 and 16, the phosphorous-containing copper alloy particles have a phosphorous content of from 6% by mass to 8% by mass. Based on the Cu-P phase diagram, this part is composed of α-Cu phase and Cu₃P phase. In the early stage of sintering, the α-Cu phase is oxidized to Cu₂O. This Cu₂O is believed to be reduced back to α-Cu. Here, it is thought that the Cu₃P phase contained in the phosphorous-containing copper alloy particle or phosphorus derived from oxidized Cu₃P phase contributes to this reduction reaction.

Accordingly, as shown in Examples 1 to 17, in those paste compositions for an electrode in which phosphorous-containing copper alloy particles having a phosphorous content of from 6% by mass to 8% by mass were used, it is thought that, even when the retention time at the maximum temperature was set to 10 to 20 seconds, oxidation of copper was suppressed during the sintering, so that electrodes having a low resistivity were formed. Further, since sintering of the phosphorous-containing copper alloy particles is more advanced by extending the sintering time, not only a more compact electrode having a low resistivity can be formed but also fire-through can be performed more effectively; therefore, an effect that the ohmic contact property between an electrode and a semiconductor substrate is improved can also be attained.

### <Example 18>

Using the paste composition 1 for an electrode obtained in the above, a photovoltaic cell 18 having the structure shown in Fig. 4 was prepared. Here, the heating treatment was performed at 850°C for 10 seconds.

When the thus obtained photovoltaic cell was evaluated in the same manner as described above, the photovoltaic cell was found to exhibit excellent properties in the same manner as described above.

### [Explanation of References]

1 CELL WAFER OF p-TYPE SILICON SUBSTRATE
2 GRID ELECTRODE FOR CURRENT COLLECTION
3 n-TYPE SEMICONDUCTOR LAYER
4 THROUGH-HOLE ELECTRODE
5 HIGH-CONCENTRATION DOPED LAYER
6 BACK SURFACE ELECTRODE
7 BACK SURFACE ELECTRODE
130 SEMICONDUCTOR SUBSTRATE
131 DIFFUSION LAYER
132 ANTI-REFLECTION LAYER
133 LIGHT-RECEIVING SURFACE ELECTRODE
134 CURRENT COLLECTION ELECTRODE
135 OUTPUT EXTRACTION ELECTRODE
136 ELECTRODE COMPONENT DIFFUSION LAYER

## Claims

1. A paste composition for an electrode, the paste composition comprising:
phosphorous-containing copper alloy particles wherein a content of phosphorous is from 6% by mass to 8% by mass;
glass particles;
a solvent; and
a resin.

2. The paste composition for an electrode according to claim 1, wherein the glass particles have a glass softening point of 600°C or lower and a crystallization starting temperature of higher than 600°C.

3. The paste composition for an electrode according to claim 1 or 2, wherein a particle diameter (D50) of the phosphorous-containing copper alloy particles is from 0.4 µm to 10 µm.

4. The paste composition for an electrode according to any one of claims 1 to 3, wherein a particle diameter (D50) of the glass particles is from 0.5 µm to 10 µm.

5. The paste composition for an electrode according to any one of claims 1 to 4, wherein a ratio of a particle diameter (D50) of the glass particles with respect to a particle diameter (D50) of the phosphorous-containing copper alloy particles is from 0.05 to 100.

6. The paste composition for an electrode according to any one of claims 1 to 5, further comprising silver particles.

7. The paste composition for an electrode according to claim 6, wherein a content of the silver particles is from 5% by mass to 65% by mass, when a total content of the phosphorous-containing copper alloy particles and the silver particles is designated as 100% by mass.

8. The paste composition for an electrode according to claim 6 or 7, wherein a total content of the phosphorous-containing copper alloy particles and the silver particles is from 70% by mass to 94% by mass, a content of the glass particles is from 0.1% by mass to 10% by mass, and a total content of the solvent and the resin is from 3% by mass to 29.9% by mass, with respect to the paste composition.

9. A photovoltaic cell having an electrode, wherein the electrode is formed by sintering the paste composition for an electrode according to any one of claims 1 to 8, after the paste composition has been applied to a silicon substrate.

## Patentansprüche

1. Pastenzusammensetzung für eine Elektrode, worin die Pastenzusammensetzung umfasst:
Phosphor-haltige Kupferlegierungspartikel, worin ein Gehalt an Phosphor 6 Massen-% bis 8 Massen-% beträgt;
Glaspartikel;
ein Lösungsmittel; und
ein Harz.

2. Pastenzusammensetzung für eine Elektrode gemäß Anspruch 1, worin die Glaspartikel einen Glaserweichungspunkt von 600°C oder weniger und eine Kristallisationsstarttemperatur von höher als 600°C aufweisen.

3. Pastenzusammensetzung für eine Elektrode gemäß Anspruch 1 oder 2, worin ein Partikeldurchmesser (D50) der Phosphor-haltigen Kupferlegierungspartikel 0,4 µm bis 10 µm beträgt.

4. Pastenzusammensetzung für eine Elektrode gemäß mindestens einem der Ansprüche 1 bis 3, worin ein Partikeldurchmesser (D50) der Glaspartikel 0,5 µm bis 10 µm beträgt.

5. Pastenzusammensetzung für eine Elektrode gemäß mindestens einem der Ansprüche 1 bis 4, worin ein Verhältnis eines Partikeldurchmessers (D50) der Glaspartikel in Bezug auf einen Partikeldurchmesser (D50) der Phosphor-haltigen Kupferlegierungspartikel 0,05 bis 100 beträgt.

6. Pastenzusammensetzung für eine Elektrode gemäß mindestens einem der Ansprüche 1 bis 5, ferner umfassend Silberpartikel.

7. Pastenzusammensetzung für eine Elektrode gemäß Anspruch 6, worin ein Gehalt der Silberpartikel 5 Massen-% bis 65 Massen-% beträgt, wenn ein Gesamtgehalt der Phosphor-haltigen Kupferlegierungspartikel und der Silberpartikel als 100 Massen-% festgelegt ist.

8. Pastenzusammensetzung für eine Elektrode gemäß Anspruch 6 oder 7, worin in Bezug auf die Pastenzusammensetzung ein Gesamtgehalt der Phosphor-haltigen Kupferlegierungspartikel und der Silberpartikel 70 Massen-% bis 94 Massen-% beträgt, ein Gehalt der Glaspartikel 0,1 Massen-% bis 10 Massen-% beträgt und ein Gesamtgehalt des Lösungsmittels und des Harzes 3 Massen-% bis 29,9 Massen-% beträgt.

9. Photovoltaikzelle mit einer Elektrode, worin die Elektrode durch Sintern der Pastenzusammensetzung für eine Elektrode gemäß mindestens einem der Ansprüche 1 bis 8 gebildet ist, nachdem die Pastenzusammensetzung auf ein Silikonsubstrat aufgetragen wurde.

## Revendications

1. Composition de pâte pour une électrode, la composition de pâte comprenant :
des particules d'alliage de cuivre contenant du phosphore dans lesquelles une teneur en phosphore va de 6 % en masse à 8 % en masse ;
des particules de verre ;
un solvant ; et
une résine.

2. Composition de pâte pour une électrode selon la revendication 1, dans laquelle les particules de verre ont un point de ramollissement de verre de 600 °C ou moins et une température de début de cristallisation supérieure à 600 °C.

3. Composition de pâte pour une électrode selon la revendication 1 ou 2, dans laquelle un diamètre de particule (D50) des particules d'alliage de cuivre contenant du phosphore est de 0,4 µm à 10 µm.

4. Composition de pâte pour une électrode selon l'une quelconque des revendications 1 à 3, dans laquelle un diamètre de particule (D50) des particules de verre est de 0,5 µm à 10 µm.

5. Composition de pâte pour une électrode selon l'une quelconque des revendications 1 à 4, dans laquelle un rapport d'un diamètre de particule (D50) des particules de verre par rapport à un diamètre de particule (D50) des particules d'alliage de cuivre contenant du phosphore est de 0,05 à 100.

6. Composition de pâte pour une électrode selon l'une quelconque des revendications 1 à 5, comprenant en outre des particules d'argent.

7. Composition de pâte pour une électrode selon la revendication 6, dans laquelle une teneur des particules d'argent va de 5 % en masse à 65 % en masse, quand une teneur totale des particules d'alliage de cuivre contenant du phosphore et des particules d'argent est désignée comme étant de 100 % en masse.

8. Composition de pâte pour une électrode selon la revendication 6 ou 7, dans laquelle une teneur totale des particules d'alliage de cuivre contenant du phosphore et des particules d'argent est de 70 % en masse à 94 % en masse, une teneur des particules de verre est de 0,1 % en masse à 10 % en masse et une teneur totale du solvant et de la résine va de 3 % en masse à 29,9 % en masse, par rapport à la composition de pâte.

9. Cellule photovoltaïque ayant une électrode, dans laquelle l'électrode est formée en frittant la composition de pâte pour une électrode selon l'une quelconque des revendications 1 à 8, après que la composition de pâte a été appliquée à un substrat de silicium.
